# EUROPEAN PATENT APPLICATION

(11) **EP 4 682 564 A1**
(43) Date of publication of application: **21.01.2026**
(21) Application number: 24865698.5
(22) Date of filing: 12.08.2024
(51) Int. Cl.: G01R 31/396, G01R 31/392, G01R 31/3842, G01R 31/385, G01R 19/10

(54) **BATTERY MANAGEMENT DEVICE AND BATTERY MANAGEMENT METHOD**

(30) Priority: 12.09.2023 KR 20230121004
(71) Applicant: LG Energy Solution, Ltd., Seoul 07335 (KR)
(72) Inventor: SEO, Bo Kyung, Daejeon 34122 (KR)
(74) Representative: Goddar, Heinz J.
(86) International application number: PCT/KR2024/012016
(87) International publication number: WO 2025/058256

(57) **Abstract**

A battery management device disclosed in the present document comprises: a sensor unit for measuring the voltage and current of a plurality of battery cells; and a control unit for generating accumulated voltage deviation data in which deviations between the voltages of the plurality of battery cells are accumulated, determining the SOC of the plurality of battery cells on the basis of the currents, generating accumulated SOC deviation data in which deviations between the SOC of the plurality of battery cells are accumulated, and determining the cause of failure of the plurality of battery cells on the basis of the accumulated voltage deviation data and the accumulated SOC deviation data.

## Description

### [TECHNICAL FIELD]

### CROSS-REFERENCE TO RELATED APPLICATION

This application claims priority to and the benefit of Korean Patent Application No. 10-2023-0121004 filed in the Korean Intellectual Property Office on September 12, 2023, the entire content of which is incorporated herein by reference.

### TECHNICAL FIELD

Embodiments disclosed herein relate to a battery management apparatus and a battery management method for diagnosing a state of a battery.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

As the occurrence of defective battery cells, such as tab disconnection or lithium precipitation, in the battery may cause safety issues during battery use, research is being conducted on a defective battery cell detection algorithm. Conventionally, a method of diagnosing whether a battery is abnormal simply based on deviations of a voltage and a state of charge (SOC) has been used. However, a conventional method has a high reference for a deviation to prevent over-diagnosis, delaying diagnosis, and has a cost loss of having to replacing related components because of failing to determine a cause for battery abnormality.

### [DISCLOSURE]

### [TECHNICAL PROBLEM]

According to an embodiment disclosed herein, provided are a battery management apparatus and a battery management method in which a cause for deviations of a voltage and an SOC may be easily identified using accumulative deviation data.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment includes a sensor unit configured to measure voltages and currents of a plurality of battery cells and a control unit configured to generate voltage deviation cumulative data obtained by accumulating a deviation between voltages of the plurality of battery cells, determine states of charge (SOCs) of the plurality of battery cells based on the currents and generate SOC deviation cumulative data obtained by accumulating a deviation between the SOCs of the plurality of battery cells, and determine defect causes of the plurality of battery cells based on the voltage deviation cumulative data and the SOC deviation cumulative data.

The control unit may be further configured to determine increasing required times of a voltage deviation and a SOC deviation based on the voltage deviation cumulative data and the SOC deviation cumulative data, and determine deviation causes corresponding to the increasing required times as the defect causes of the plurality of battery cells.

The control unit may be further configured to determine deviation counts of a voltage deviation and a SOC deviation based on the voltage deviation cumulative data and the SOC deviation cumulative data, and determine deviation causes corresponding to the deviation counts as the defect causes of the plurality of battery cells.

The control unit may be further configured to determine maximum deviations of a voltage deviation and a SOC deviation based on the voltage deviation cumulative data and the SOC deviation cumulative data, and determine deviation causes corresponding to the maximum deviations as the defect causes of the plurality of battery cells.

The control unit may be further configured to determine a required time from a maximum deviation occurrence time to a next maximum deviation occurrence time based on the voltage deviation cumulative data and the SOC deviation cumulative data and determine a deviation cause corresponding to the required time as a defect cause of the plurality of battery cells.

The control unit may be further configured to determine a maximum deviation occurrence speed based on the required time and determine a deviation cause corresponding to the maximum deviation occurrence speed as a defect cause of the plurality of battery cells.

The control unit may be further configured to reset the cumulative data based on that the voltage deviation cumulative data and the SOC deviation cumulative data fall within a normal range.

The control unit may be further configured to store a maximum deviation up to a reset time based on that the cumulative data is reset wherein a previously stored maximum deviation is compared with the maximum deviation up to the reset time and a greater value therebetween is stored.

A battery management method according to an embodiment includes measuring voltages and currents of a plurality of battery cells, generating voltage deviation cumulative data obtained by accumulating a deviation between voltages of the plurality of battery cells, determining states of charge (SOCs) of the plurality of battery cells based on the currents, generating SOC deviation cumulative data obtained by accumulating a deviation between the SOCs of the plurality of battery cells, and determining defect causes of the plurality of battery cells based on the voltage deviation cumulative data and the SOC deviation cumulative data.

The determining of the defect causes of the plurality of battery cells may include determining increasing required times of a voltage deviation and a SOC deviation based on the voltage deviation cumulative data and the SOC deviation cumulative data, and determining deviation causes corresponding to the increasing required times as the defect causes of the plurality of battery cells.

The determining of the defect causes of the plurality of battery cells may include determining deviation counts of a voltage deviation and a SOC deviation based on the voltage deviation cumulative data and the SOC deviation cumulative data, and determining deviation causes corresponding to the deviation counts as the defect causes of the plurality of battery cells.

The determining of the defect causes of the plurality of battery cells may include determining maximum deviations of a voltage deviation and a SOC deviation based on the voltage deviation cumulative data and the SOC deviation cumulative data, and determining deviation causes corresponding to the maximum deviations as the defect causes of the plurality of battery cells.

The determining of the defect causes of the plurality of battery cells may include determining a required time from a maximum deviation occurrence time to a next maximum deviation occurrence time based on the voltage deviation cumulative data and the SOC deviation cumulative data and determining a deviation cause corresponding to the required time as a defect cause of the plurality of battery cells.

The determining of the defect causes of the plurality of battery cells may include determining a maximum deviation occurrence speed based on the required time and determining a deviation cause corresponding to the maximum deviation occurrence speed as a defect cause of the plurality of battery cells.

The battery management method may further include resetting the cumulative data based on that the voltage deviation cumulative data and the SOC deviation cumulative data fall within a normal range.

The battery management method may further include storing a maximum deviation up to a reset time based on that the cumulative data is reset wherein a previously stored maximum deviation is compared with the maximum deviation up to the reset time and a greater value therebetween is stored.

### [ADVANTAGEOUS EFFECTS]

With a battery management apparatus according to an embodiment, a cause for a voltage or SOC deviation may be classified based on deviation cumulative data, thereby reducing a cost loss by replacing a cause component without replacing all the components related to battery abnormality.

With the battery management apparatus according to an embodiment, a cause for a voltage or SOC deviation may be analyzed to perform balancing without replacement of a component, thereby reducing the deviation and thus reducing a time and a cost required for cause analysis.

### [DESCRIPTION OF DRAWINGS]

FIG. 1 is a block diagram showing a configuration of a general battery system including a battery management apparatus according to an embodiment.
FIG. 2 is a block diagram showing a configuration of a battery management apparatus according to an embodiment.
FIG. 3 schematically shows a type of data stored in a memory in a battery management apparatus according to an embodiment.
FIG. 4 schematically shows a flow for a battery management apparatus according to an embodiment to determine a cause for a defect of a battery.
FIG. 5 shows a state change of a battery management apparatus according to an embodiment.
FIG. 6 shows a value stored based on a state change in a battery management apparatus according to an embodiment.
FIGS. 7 to 10 are graphs showing deviation cumulative data obtained in a battery management apparatus according to an embodiment.
FIG. 11 is a flowchart of a battery management method according to an embodiment.
FIG. 12 is a flowchart continuously showing the battery management method of FIG. 11.

### [MODE FOR INVENTION]

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1^{st}, "2^{nd}" "first", "second", or the like may modify various components regardless of order and/or importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may not be interpreted to exclude embodiments disclosed herein.

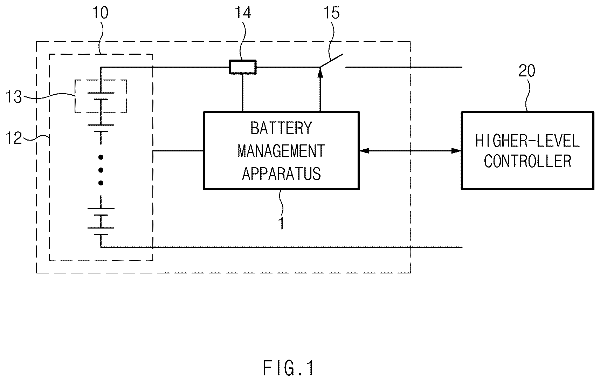

FIG. 1 is a block diagram showing a configuration of a general battery system including a battery management apparatus according to various embodiments.

Specifically, FIG. 1 schematically shows a battery system 10 and a higher-level controller 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a cathode, a cathode material, an anode, an anode material, a separator, polymer, and a case. In this case, the plurality of battery modules 12 may be connected in series or in parallel.

The sensor unit 14 may include a current sensor 2, a voltage sensor 3, and a temperature sensor (not shown).

The current sensor 2 may detect a current used in a process of determining an SO C of the battery cell 13.

The current sensor 2 may include any component for generating a signal corresponding to a magnitude of a charging current, and may be installed on a charging/discharging path in which the charging/discharging current flows in a battery.

The current sensor 2 may measure a battery current flowing in the battery, i.e., a charging current and a discharging current, and transmit a measurement result to the battery management apparatus 1. According to an embodiment, the current sensor 2 may measure the battery current at predetermined intervals and transmit a measurement result to the battery management apparatus 1, in a charging cycle for charging the battery with power of an external device or a discharging cycle for discharging the battery.

The voltage sensor 3 may be connected in parallel with the battery and configured to detect a battery voltage across opposite ends of the battery and generate a voltage signal indicating the detected battery voltage.

The temperature sensor may be configured to measure a battery temperature and generate a temperature signal indicating the measured battery temperature. The temperature sensor may be disposed in a case to measure a temperature close to an actual temperature of the battery. For example, the temperature sensor may be attached to a surface of at least one battery cell included in a cell group and detect the surface temperature of the battery cell as the battery temperature.

The temperature sensor may be configured to measure an external temperature that is a temperature at a predetermined position spaced apart from the battery and generate the temperature signal indicating the measured external temperature. The temperature sensor may be arranged at a predetermined position outside the case in which heat exchange is made between the battery and the atmosphere. According to an embodiment, the temperature sensor may be implemented in combination of one or two or more of known temperature detection elements such as a thermocouple, a thermistor, a bimetal, etc. The sensor unit 14 may detect current flowing in the battery system 10. In this case, a detection signal may be transmitted to the battery management apparatus 1.

While the sensor unit 14 is connected between a positive electrode of the battery cell 13 and the switching unit 16 in FIG. 1, a connection relationship between components shown in FIG. 1 may be an example and is not limited thereto.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a BMS.

The battery management apparatus 1, which is an interface for receiving measurement values of the above-described various parameter values, may include a plurality of terminals and a circuit, etc., connected thereto to process input values. Further, the battery management apparatus 1 may control the switching unit 16, for example, on/off of a relay, a contactor, etc., and may be connected to the battery module 12 to monitor a state of each battery module 12.

The battery management apparatus 1 may receive temperature data, voltage data, and current data from the sensor unit 14 to obtain battery state information and diagnose a state of the battery.

The higher-level controller 20 may transmit a control signal for controlling the battery module 12 to the battery management apparatus 1. Thus, the battery management apparatus 1 may be controlled in terms of an operation thereof based on the control signal applied from the higher-level controller 20. Also, the battery module 12 may be a component included in an energy storage system (ESS). In this case, the higher-level controller 20 may be a control unit (BBMS) of a battery bank including the plurality of battery systems 10 or an ESS control unit for controlling the entire ESS including a plurality of banks. However, the battery system 10 is not limited to such a purpose.

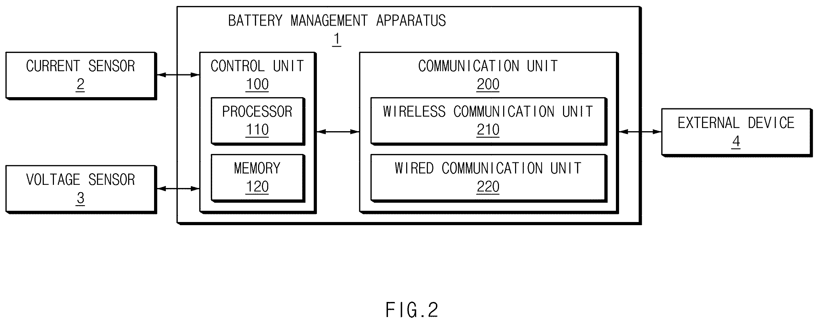

FIG. 2 is a block diagram showing a configuration of a battery management apparatus according to an embodiment.

Referring to FIG. 2, the battery management apparatus 1 according to an embodiment may include a control unit 100 including at least one processor 110 and a memory 120 and a communication unit 200, and may diagnose a battery by communicating with an external device 4 through the communication unit 200.

According to an embodiment, the external device 4 communicating with the battery management apparatus 1 may include a user terminal that transmits a diagnosis result of the battery management apparatus 1.

Specifically, when the external device 4 is a user terminal, the control unit 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

When the external device 4 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 4. The communication unit 200 may transmit and receive a program for feature calculation, class classification, and lifespan estimation for a battery cell or various data, etc., to and from a separately provided external server.

The wireless communication unit 210 may include at least one of a short-range communication module or a long-range communication module.

The short-range communication module may communicate with the external device 4 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range communication module may include a communication module performing various types of long-range communication, and may include a mobile communication unit. The mobile communication unit may transmit and receive a radio signal to and from at least one of a base station, an external terminal, or the external device 4 over a mobile communication network. The long-range communication module may communicate with the external device 4 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the WAN with the external device 4 to communicate with each other.

The wired communication unit 220 may access the wired communication network and communicate with the external device 4 through the wired communication network. For example, the wired communication unit 220 may access the wired communication network through Ethernet (IEEE 802.3, technical standards), access the wired communication network through CAN communication, and transmit and receive data to and from the external devices 4 through the wired communication network.

The battery management apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery management apparatus 1. Specifically, the memory 120 may store an operating system and a program required for driving of the battery management apparatus 1 or store data required for driving of the battery management apparatus 1.

Specifically, the memory 120 may store various programs regarding feature calculation, class classification, and lifespan estimation of the battery cell. Moreover, the memory 120 may store various data such as a voltage, a current, feature data, etc., of each battery cell.

The memory 120 may also store the SOC and the SOH of the battery cell 13, estimated by the processor 110.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the control unit 100 that controls the above-described components to determine whether a failure occurs in a battery cell.

Specifically, the control unit 100 may generate voltage deviation cumulative data obtained by accumulating a deviation between voltages measured in a plurality of battery cells and generate SOC deviation cumulative data obtained by accumulating a deviation between SOCs of the plurality of battery cells.

To this end, the control unit 100 may determine the SOCs of the plurality of battery cells based on currents measured in the plurality of battery cells.

The control unit 100 may determine increasing required times of a voltage deviation and an SOC deviation based on the voltage deviation cumulative data and the SOC deviation cumulative data, and determine deviation causes corresponding to the increasing required times as defect causes of the plurality of battery cells.

The control unit 100 may determine the number of deviation occurrences of the voltage deviation and the SOC deviation based on the voltage deviation cumulative data and the SOC deviation cumulative data and determine deviation causes corresponding to the number of deviation occurrences as the defect causes of the plurality of battery cells.

The control unit 100 may determine maximum deviations of the voltage deviation and the SOC deviation based on the voltage deviation cumulative data and the SOC deviation cumulative data and determine deviation causes corresponding to the maximum deviations as the defect causes of the plurality of battery cells.

The control unit 100 may determine a required time from a maximum deviation occurrence time to a next maximum deviation occurrence time based on the voltage deviation cumulative data and the SOC deviation cumulative data and determine a deviation cause corresponding to the required time as a defect cause of the plurality of battery cells.

The control unit 100 may determine a maximum deviation occurrence speed based on the required time, determine a deviation cause corresponding to the maximum deviation occurrence speed as a defect cause of the plurality of battery cells, and in this way, the control unit 100 may match various factors to deviation causes to determine a defect cause of a battery cell.

The control unit 100 may also reset cumulative data based on that the voltage deviation cumulative data and the SOC deviation cumulative data fall in a normal range, and may store a maximum deviation to a reset time based on the cumulative data being reset, compare the maximum deviation to the reset time with a previously stored maximum deviation, and store the greater value. As such, the control unit 100 may continuously update the maximum deviation to determine a deviation cause.

In this way, the battery management apparatus according to an embodiment may diagnose whether a defect occurs in a battery cell by using voltage deviation cumulative data and SOC deviation cumulative data of the battery cell, thereby significantly improv ing the reliability of diagnosis.

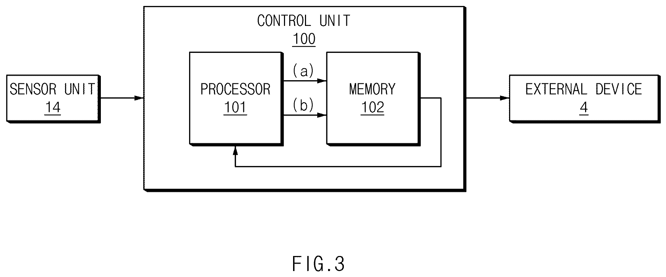

FIG. 3 schematically shows a type of data stored in the memory 120 in a battery management apparatus according to an embodiment.

Referring to FIG. 3, the control unit 100 may receive currents and voltages of the plurality of battery cells from the sensor unit 14. The processor 110 of the control unit 100 may calculate an SOC of a battery cell based on the received current, and SOC calculation may use a current integration method or an open circuit voltage (OCV) measurement method.

The processor 110 may generate deviation data a including voltage deviation data and SOC deviation data based on the received voltage and the calculated SOC. The processor 110 may identify according to a battery use mode, and generate deviation cumulative data b including voltage deviation cumulative data and SOC deviation cumulative data.

As such, the battery management apparatus according to an embodiment may store both the deviation data a and the deviation cumulative data b in the memory 120. That is, unlike a conventional technique for storing only the deviation data a in the memory 120, the deviation data a and the deviation cumulative data b regarding a deviation increase/decrease may be stored in a storage unit.

Thus, the processor 110 of the control unit 100 may match a battery use mode to a deviation cumulative tendency by using the deviation cumulative data b according to the battery use mode, thereby deriving a cause for battery defect. Thereafter, the control unit 100 may transmit a defect cause of the battery to the external device 4 including the user terminal and the server device.

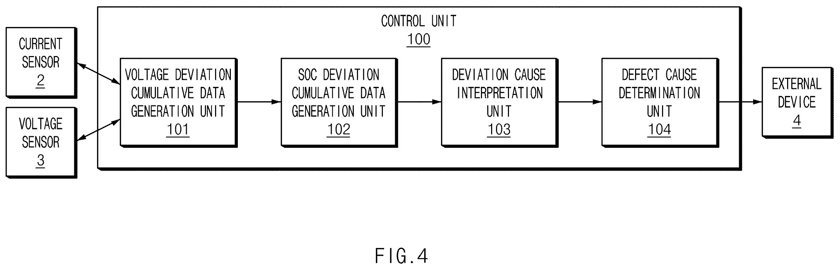

FIG. 4 schematically shows a flow for a battery management apparatus according to an embodiment to determine a cause for a defect of a battery.

Referring to FIG. 4, the control unit 100 of the battery management apparatus according to an embodiment may receive a battery voltage value and a battery current value at a specific point in time from the voltage sensor 3 and the current sensor 2 and determine an SOC of a battery cell based on the current value.

Thereafter, a voltage deviation cumulative data generation unit 101 of the control unit 100 may accumulate a difference between voltage of battery cells to generate voltage deviation cumulative data. In addition, an SOC deviation cumulative data generation unit 102 of the control unit 100 may generate SOC deviation cumulative data by accumulating a difference between a preset reference SOC and a calculated SOC of battery cells.

A voltage deviation Vdev may be determined as a value obtained by subtracting a minimum voltage Vmin from a maximum voltage Vmax among battery cells or the minimum voltage Vmin from a median voltage Vmedian among the battery cells.

While it is shown in FIG. 4 that the voltage deviation cumulative data is first generated and the SOC deviation cumulative data is generated later, the order is not limited such that the SOC deviation cumulative data may be generated first and the voltage deviation cumulative data may be generated later, or both of them may be simultaneously generated in parallel.

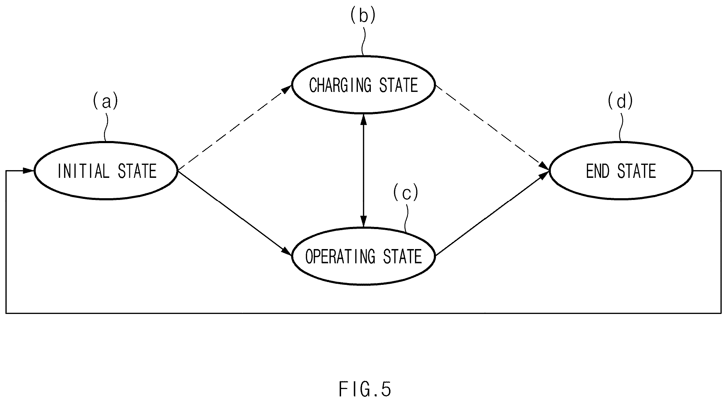

Thereafter, a deviation cause interpretation unit 103 of the control unit 100 may determine a deviation cause based on the SOC deviation cumulative data and the voltage deviation cumulative data, and specifically, the control unit 100 may generate and visualize cumulative data according to a battery use mode, interpret the visualized graph, and determine the deviation cause. This will be described below in detail with reference to FIG. 5.

A defect cause determination unit 104 of the control unit 100 may determine a defect cause corresponding to the determined deviation cause. That is, when the deviation cause is determined, the control unit 100 may match the deviation cause to a pre-typed defect cause and transmit the defect cause to the external device 4.

For example, the control unit 100 may determine that a deviation is reduced through cell balancing when the deviation is reduced in the SOC deviation cumulative data in battery charging, and the control unit 100 may determine that there is no problem in a cell balancing function.

In another example, the control unit 100 may determine that the deviation may not be reduced through cell balancing when the deviation is maintained constant in the SOC deviation cumulative data in battery charging, and the control unit 100 may determine that there is a problem in the cell balancing function.

Thus, the control unit 100 may determine that the deviation cause is a failure to perform a cell balancing operation, and determine a typed defect cause as a cell balancing malfunction.

Thereafter, the control unit 100 may transmit a signal or message regarding the cell balancing malfunction to the external device 4, and the user may diagnose the battery based on the signal or message regarding the cell balancing malfunction, transmitted to the external device 4.

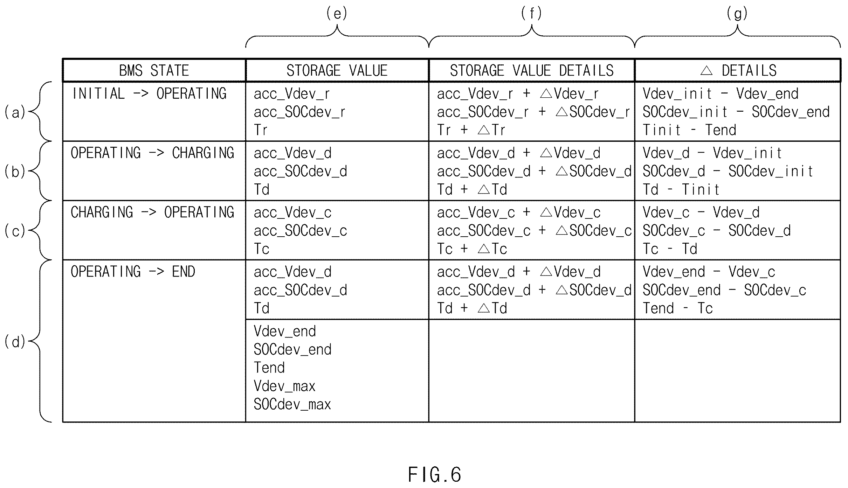

FIG. 5 shows a state change of a battery management apparatus according to an embodiment, and FIG. 6 shows a value stored based on a state change in a battery management apparatus according to an embodiment.

Referring to FIG. 5, a state of the battery management apparatus may be changed according to a battery use mode and may be divided into an initial state (a), a charging state (b), an operating state (c), and an end state (d). That is, the initial state (a) may mean a standby state as a state before use of a battery, the charging state (b) may mean a state where the battery is connected to a power source and is being charged, the operating state (c) may mean a state in which the battery is being discharged by being used, and the end state (d) may mean a state in which the charging state (b) or the operating state (d) is terminated.

For example, referring to a solid-line part of FIG. 5, the state of the battery management apparatus according to the battery use mode may be changed from the initial state (a) to the operating state (c), from the operating state (c) to the charging state (b), from the charging state (b) to the operating state (c), from the operating state (c) to the end state (d), and from the end state (d) to the initial state (a), thus forming one cycle.

Next, referring to FIG. 6, a value stored in the memory 120 may be determined according to a state change of the battery management apparatus of FIG. 5.

First, in (a) where the state of the battery management apparatus changes from the initial state to the operating state, the control unit 100 may store, as a storage value e, voltage deviation cumulative data acc_Vdev_r, SOC deviation cumulative data acc_SOCdev_r, and cumulative time data Tr, in the memory 120.

Referring to storage value details f, the voltage deviation cumulative data acc_Vdev_r may be determined as a value (acc_Vdev_r = acc_Vdev_r + △Vdev_r) obtained by adding a voltage deviation variance △Vdev_r to immediately previous voltage deviation cumulative data acc_Vdev_r. The SOC deviation cumulative data acc_SOCdev_r may be determined as a value (acc_SOCdev_r = acc_SOCdev_r + △ SOCdev_r) obtained by adding an SOC deviation variance △SOCdev_r to immediately previous SOC deviation cumulative data acc_SOCdev_r. The cumulative time data Tr may be determined as a value (Tr = Tr + △Tr) obtained by adding a cumulative time variance △Tr to immediately previous cumulative time data Tr.

Referring to delta △ details g, the voltage deviation variance △Vdev_r may mean a value (△Vdev_r = Vdev_init - Vdev_end) obtained by subtracting a voltage deviation Vdev_end in the end state at an immediately previous stage from a voltage deviation Vdev_init in the initial state. The SOC deviation variance △SOCdev_r may mean a value (△SOCdev_r = SOCdev_init - SOCdev_end) obtained by subtracting an SOC deviation SOCdev_end in the end state at the immediately previous stage from an SOC deviation SOCdev_init in the initial state. The cumulative time variance △Tr may mean a value (△Tr = Tinit - Tend) obtained by subtracting a cumulative time Tend in the end state at the immediately previous stage from the cumulative time T_init in the initial state.

Next, in (b) where the state of the battery management apparatus changes from the operating state to the charging state, the control unit 100 may store, as the storage value e, voltage deviation cumulative data acc_Vdev_d, SOC deviation cumulative data acc_SOCdev_d, and cumulative time data Td, in the memory 120.

Referring to the storage value details f, the voltage deviation cumulative data acc_Vdev_d may be determined as a value (ace_Vdev_d = acc_Vdev_d + △Vdev_d) obtained by adding a voltage deviation variance △Vdev_d to immediately previous voltage deviation cumulative data acc_Vdev_d. The SOC deviation cumulative data acc_SOCdev_d may be determined as a value (acc_SOCdev_d = acc_SOCdev_d + △ SOCdev_d) obtained by adding an SOC deviation variance Δ SOCdev_d to immediately previous SOC deviation cumulative data acc_SOCdev_d. The cumulative time data Td may be determined as a value (Td = Td + △Td) obtained by adding a cumulative time variance △Td to immediately previous cumulative time data Td.

Referring to the delta △ details g, the voltage deviation variance △Vdev_d may mean a value (ΔVdev_d = Vdev_d - Vdev_init) obtained by subtracting a voltage deviation Vdev_init in the initial state at an immediately previous stage from a voltage deviation Vdev_d in the operating state. The SOC deviation variance △SOCdev_d may mean a value (△SOCdev_d= SOCdev_d - SOCdev_init) obtained by subtracting an SOC deviation SOCdev_init in the initial state at the immediately previous stage from an SOC deviation SOCdev_d in the operating state. The cumulative time variance △Td may mean a value (△Td = Td - Tinit) obtained by subtracting a cumulative time Tinit in the initial state at the immediately previous stage from the cumulative time T_d in the operating state.

Next, in (c) where the state of the battery management apparatus changes from the charging state to the operating state, the control unit 100 may store, as the storage value e, voltage deviation cumulative data acc_Vdev_c, SOC deviation cumulative data acc_SOCdev_c, and cumulative time data Tc, in the memory 120.

Referring to the storage value details f, the voltage deviation cumulative data acc_Vdev_c may be determined as a value (acc_Vdev_c = acc_Vdev_c + △Vdev_c) obtained by adding a voltage deviation variance △Vdev_c to immediately previous voltage deviation cumulative data acc_Vdev_c. The SOC deviation cumulative data acc_SOCdev_c may be determined as a value (acc_SOCdev_c = acc_SOCdev_c + △ SOCdev_c) obtained by adding an SOC deviation variance △SOCdev_c to immediately previous SOC deviation cumulative data acc_SOCdev_c. The cumulative time data Tc may be determined as a value (Tc = Tc + △Tc) obtained by adding a cumulative time variance △Tc to immediately previous cumulative time data Tc.

Referring to the delta △ details g, the voltage deviation variance △Vdev_c may mean a value (ΔVdev_c = Vdev_c - Vdev_d) obtained by subtracting a voltage deviation Vdev_d in the operating state at an immediately previous stage from a voltage deviation Vdev_c in the charging state. The SOC deviation variance △SOCdev_c may mean a value (△SOCdev_c = SOCdev_c - SOCdev_d) obtained by subtracting an SOC deviation SOCdev_d in the operating state at the immediately previous stage from an SOC deviation SOCdev_c in the charging state. The cumulative time variance △Tc may mean a value (△Tc = Tc - Td) obtained by subtracting a cumulative time Td in the operating state at the immediately previous stage from the cumulative time T_c in the charging state.

Next, in (d) where the state of the battery management apparatus changes from the operating state to the end state, the control unit 100 may store, as the storage value e, voltage deviation cumulative data acc_Vdev_d, SOC deviation cumulative data acc_SOCdev_d, and cumulative time data Td, in the memory 120. In the end state, the voltage deviation Vdev_end, the SOC deviation SOCdev_end, a measurement time Tend, the voltage maximum deviation Vdev_max, and the SOC maximum deviation SOCdev_max may be stored together with the cumulative data. Thus, as described above, the control unit 100 may use non-cumulative deviation data as well as cumulative deviation data to determine whether the battery cell is abnormal.

Referring to the storage value details f, the voltage deviation cumulative data acc_Vdev_d may be determined as a value (ace_Vdev_d = acc_Vdev_d + △Vdev_d) obtained by adding a voltage deviation variance △Vdev_d to immediately previous voltage deviation cumulative data acc_Vdev_d. The SOC deviation cumulative data acc_SOCdev_d may be determined as a value (acc_SOCdev_d = acc_SOCdev_d + △ SOCdev_d) obtained by adding an SOC deviation variance Δ SOCdev_d to immediately previous SOC deviation cumulative data acc_SOCdev_d. The cumulative time data Td may be determined as a value (Td = Td + △Td) obtained by adding a cumulative time variance △Td to immediately previous cumulative time data Td.

Referring to the delta △ details g, the voltage deviation variance △Vdev_d may mean a value (△Vdev_d = Vdev_end - Vdev_c) obtained by subtracting the voltage deviation Vdev_c in the charging state at an immediately previous stage from the voltage deviation Vdev_end in the end state. The SOC deviation variance △SOCdev_d may mean a value (△SOCdev_d = SOCdev_end - SOCdev_c) obtained by subtracting the SOC deviation SOCdev_c in the charging state at the immediately previous stage from the SOC deviation SOCdev_end in the end state. The cumulative time variance △Td may mean a value (△Td = Tend - Tc) obtained by subtracting the cumulative time Tc in the initial state at the immediately previous stage from the cumulative time Tend in the operating state.

The above-described storage values are examples, and may be modified variously according to a charging/discharging cycle. Hereinbelow, a description will be made of a process, performed by a battery management apparatus according to an embodiment, of determining a defect cause based on a storage value.

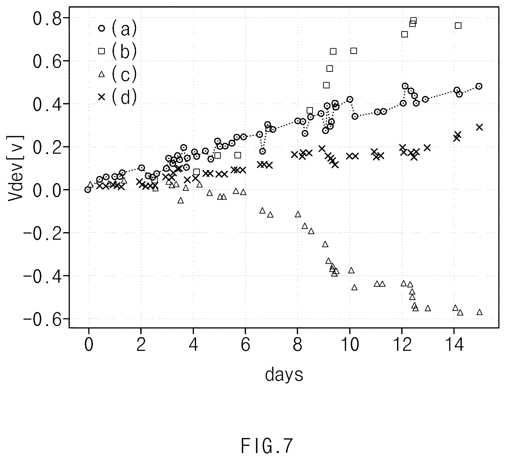

FIGS. 7 to 10 are graphs showing deviation cumulative data obtained in a battery management apparatus according to an embodiment.

Referring to FIG. 7, the control unit 100 may generate and visualize cumulative data according to a battery use mode and interpret the visualized graph to determine a deviation cause. In FIG. 7, (a) may mean a total voltage deviation V_dev, (b) may mean voltage deviation cumulative data acc_Vdev_c in a charging mode, (c) may mean voltage deviation cumulative data acc_Vdev_d in an operating mode, and (d) may mean voltage deviation cumulative data acc_Vdev_end in an end or rest mode.

It may be seen from FIG. 7 that a voltage deviation of a battery cell globally increases based on that the total voltage deviation (a) increases. Moreover, the battery management apparatus according to an embodiment may obtain deviation cumulative data according to the battery use mode, thereby determining a deviation cause and a defect cause corresponding thereto.

In addition, as the voltage deviation cumulative data (b) in the charging mode is accumulated with a positive deviation and the voltage deviation cumulative data (c) in the operating mode is accumulated with a negative deviation, the control unit 100 may determine a corresponding deviation cause. As the voltage deviation cumulative data (d) in the end or rest mode is accumulated with a positive deviation, the corresponding deviation cause may be determined.

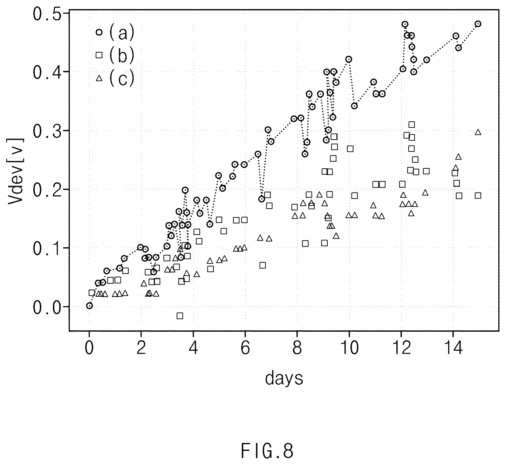

Referring to FIG. 8 together, in FIG. 8, (a) may mean a total voltage deviation V_dev, (b) may mean voltage deviation cumulative data acc_Vdev_on in a charging/discharging mode, and (c) may mean voltage deviation cumulative data acc_Vdev_end in the rest mode.

In FIG. 7, the voltage deviation cumulative data in the charging mode and the voltage deviation cumulative data in the operating mode may respectively have a positive deviation and a negative deviation, and in FIG. 8, the voltage deviation cumulative data (b) in the charging/discharging mode including the charging mode and the operating mode may be indicated as having a positive deviation with a small slope as the positive deviation and the negative deviation are offset.

Thus, the control unit 100 may determine that a rate at which the voltage deviation cumulative data (c) in the rest mode affects an increase in the total voltage deviation (a) is greater than that of the voltage deviation cumulative data (b) in the charging/discharging mode. Thereafter, the control unit 100 may determine a deviation cause by determining the rate affecting the increase in the total voltage deviation (a), and determine a corresponding defect cause.

For example, when it is assumed that a voltage deviation increase speed is 32 mV/day, the control unit 100 may determine that that speed is similar to a deviation increase speed in the low-voltage state, thereby determining the deviation cause as a low voltage, selecting a corresponding defect cause, and transmitting the same to the external device 4.

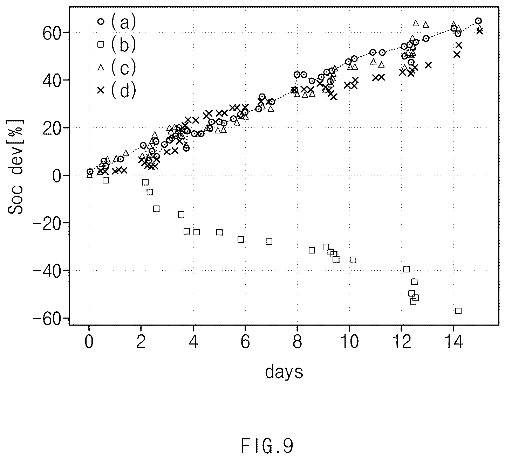

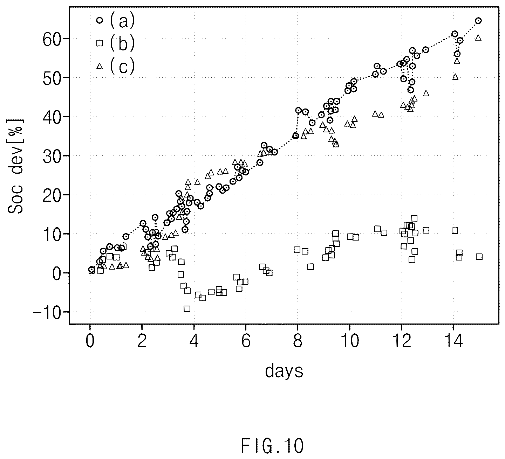

Likewise, referring to FIGS. 9 and 10, the control unit 100 may generate and visualize cumulative data according to a battery use mode and interpret the visualized graph to determine a deviation cause. In FIG. 9, (a) may mean a total SOC deviation SOC_dev, (b) may mean SOC deviation cumulative data acc_SOCdev_c in the charging mode, (c) may mean SOC deviation cumulative data acc_SOCdev_d in the operating mode, and (d) may mean SOC deviation cumulative data acc_SOCdev_end in the end or rest mode.

It may be seen from FIG. 9 that an SOC deviation of a battery cell globally increases based on that the total SOC deviation (a) increases. Moreover, the battery management apparatus according to an embodiment may obtain deviation cumulative data according to the battery use mode, thereby determining a deviation cause and a defect cause corresponding thereto.

In addition, as the SOC deviation cumulative data (b) in the charging mode is accumulated with a negative deviation and the SOC deviation cumulative data (c) in the operating mode is accumulated with a positive deviation, the control unit 100 may determine a corresponding deviation cause. As the SOC deviation cumulative data (d) in the end or rest mode is accumulated with a positive deviation, the corresponding deviation cause may be determined.

Referring to FIG. 10 together, in FIG. 10, (a) may mean a total SOC deviation SOC_dev, (b) may mean SOC deviation cumulative data acc_SOCdev_on in the charging/discharging mode, and (c) may mean SOC deviation cumulative data acc_SOCdev_end in the rest mode.

In FIG. 9, the SOC deviation cumulative data in the charging mode and the SOC deviation cumulative data in the operating mode may respectively have a negative deviation and a positive deviation, and in FIG. 10, the SOC deviation cumulative data (b) in the charging/discharging mode including the charging mode and the operating mode may be indicated as a near-horizontal graph as the positive deviation and the negative deviation are offset.

Thus, the control unit 100 may determine that a cause affecting an increase in the total SOC deviation (a) originates from the rest mode. For example, when it is assumed that an SOC deviation increase speed is 4.3 %/day, the control unit 100 may determine that that speed is similar to a deviation increase speed in the low-voltage state, thereby determining the deviation cause as a low voltage, selecting a corresponding defect cause, and transmitting the same to the external device 4.

As such, the battery management apparatus according to an embodiment may use cumulative deviation data in addition to voltage and SOC deviations, thereby analyzing a battery defect cause in more detail.

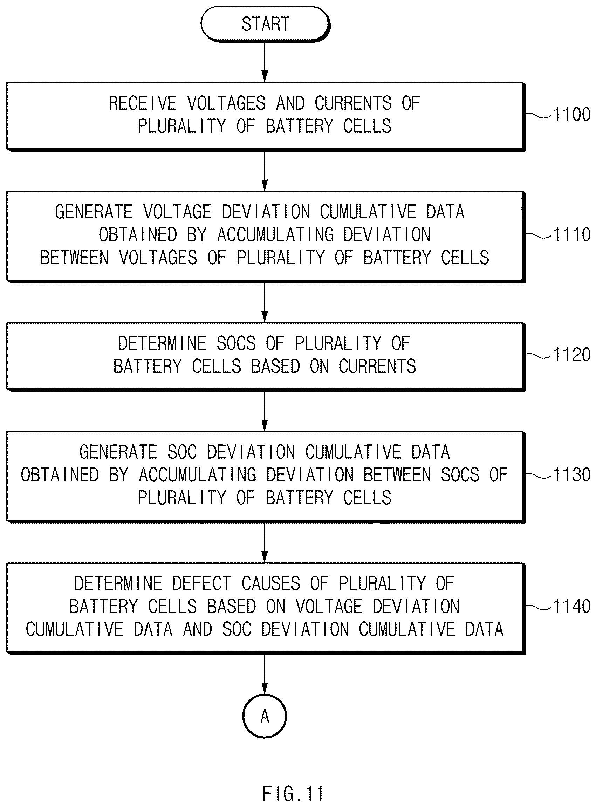

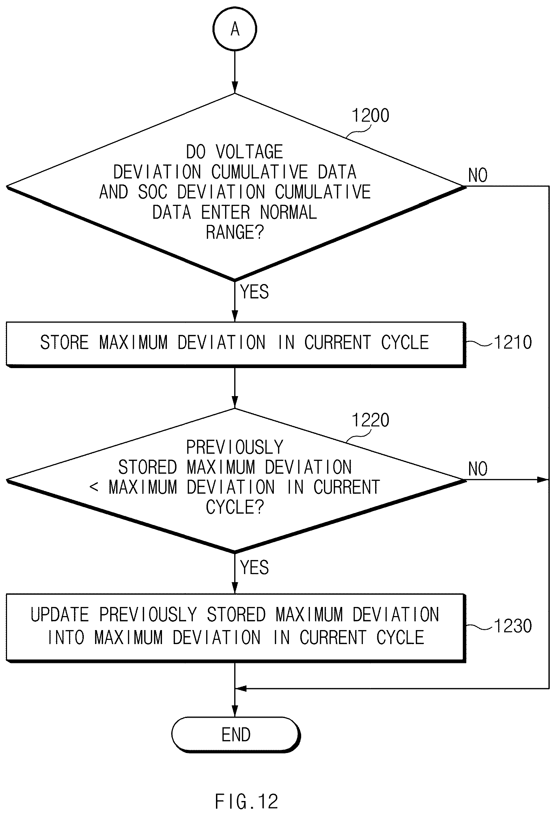

FIG. 11 is a flowchart of a battery management method according to an embodiment, and FIG. 12 is a flowchart continuously showing the battery management method of FIG. 11.

Referring to FIG. 11, the control unit 100 may receive currents and voltages of the plurality of battery cells from the sensor unit 14 in operation 1100. Thereafter, the control unit 100 may generate voltage deviation cumulative data by cumulating a deviation between voltages of a plurality of battery cells, in operation 1110.

The control unit 100 may determine the SOCs of the plurality of battery cells based on currents of the plurality of battery cells, in operation 1120. Thereafter, the control unit 100 may generate SOC deviation cumulative data by cumulating a deviation between SOCs of the plurality of battery cells, in operation 1130.

In this case, the control unit 100 may determine defect causes of the plurality of battery cells based on voltage deviation cumulative data and SOC deviation cumulative data, in operation 1140. Specifically, the control unit 100 may determine a defect cause of a battery cell based on information that may be obtained from each of the voltage deviation cumulative data and the SOC deviation cumulative data or determine the defect cause of the battery cell based on information that may be obtained by analyzing the voltage deviation cumulative data and the SOC deviation cumulative data together.

Continuously referring to FIG. 12, the control unit 100 may determine whether the voltage deviation cumulative data and the SOC deviation cumulative data enter a normal range, in operation 1200. That is, the control unit 100 may determine that voltage deviation cumulative data and the SOC deviation cumulative data enter the normal range when deviations indicated in the voltage deviation cumulative data and the SOC deviation cumulative data decrease to within a reference range. The control unit 100 may determine whether the deviation cumulative data enter the normal range, thereby using the determination to identify a deviation cause.

For example, when the voltage deviation cumulative data and the SOC deviation cumulative data show deviations in a range determined as a defect of a battery during a random first time and enter the normal range after the first time, the control unit 100 may use the first time as a factor for deviation cause analysis.

In this case, the control unit 100 may increase a deviation count COUNTdev when the voltage deviation cumulative data and the SOC deviation cumulative data enter the normal range. When the voltage deviation cumulative data and the SOC deviation cumulative data enter the normal range, the control unit 100 may initialize voltage deviation cumulative data, SOC deviation cumulative data, elapsed time cumulative data, a final voltage deviation, a final SOC deviation, a final elapsed time, a maximum voltage deviation, and a final SOC deviation, which correspond to the storage value e of FIG. 6.

However, the control unit 100 may exclude a deviation change in the normal range from a deviation count based on maximum deviations Vdev_max and SOCdev_max in charging/discharging cycles according to the battery use mode.

The control unit 100 may store a maximum deviation of a current charging/discharging cycle temporarily in operation 1210 when determining that the voltage deviation cumulative data and the SOC deviation cumulative data enter the normal range (Yes in operation 1200).

Thereafter, the control unit 100 may compare a maximum deviation previously stored in a previous charging/discharging cycle with a maximum deviation in a current cycle, in operation 1220. When the control unit 100 determines that the maximum deviation in the current cycle is greater than the maximum deviation previously stored in the previous charging/discharging cycle, the control unit 100 may update the previously stored maximum deviation into the maximum deviation in the current cycle, in operation 1230.

Thus, the control unit 100 may continuously update the maximum deviation to determine the defect cause of the battery cell according to maximum values of the voltage and SOC deviations occurring in the battery cell.

Moreover, the control unit 100 may assign the user with an authority to initialize data of the deviation count COUNT _dev and data of the maximum deviations Vdex_max and SOCdev_max only when the user resolves the defect cause of the battery cell. Thus, the reliability of the data of the deviation count COUNT _dev and the data of the maximum deviation Vdex_max and SOCdev_max may be improved.

As such, the battery management apparatus according to an embodiment may use the voltage and SOC deviation cumulative data in addition to the voltage and SOC deviation data, thereby diagnosing the battery defect cause in more detail.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include read-only memory (ROM), random-access memory (RAM), a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment of the disclosure, a method according to various embodiments of the disclosure may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., PlayStore^{™}), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or the memory 102 of a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A battery management apparatus comprising:
a sensor unit configured to measure voltages and currents of a plurality of battery cells; and
a control unit configured to:
generate voltage deviation cumulative data obtained by accumulating a deviation between voltages of the plurality of battery cells;
determine states of charge (SOCs) of the plurality of battery cells based on the currents and generate SOC deviation cumulative data obtained by accumulating a deviation between the SOCs of the plurality of battery cells; and
determine defect causes of the plurality of battery cells based on the voltage deviation cumulative data and the SOC deviation cumulative data.

2. The battery management apparatus of claim 1, wherein the control unit is further configured to determine increasing required times of a voltage deviation and a SOC deviation based on the voltage deviation cumulative data and the SOC deviation cumulative data, and determine deviation causes corresponding to the increasing required times as the defect causes of the plurality of battery cells.

3. The battery management apparatus of claim 1, wherein the control unit is further configured to determine deviation counts of a voltage deviation and a SOC deviation based on the voltage deviation cumulative data and the SOC deviation cumulative data, and determine deviation causes corresponding to the deviation counts as the defect causes of the plurality of battery cells.

4. The battery management apparatus of claim 1, wherein the control unit is further configured to determine maximum deviations of a voltage deviation and a SOC deviation based on the voltage deviation cumulative data and the SOC deviation cumulative data, and determine deviation causes corresponding to the maximum deviations as the defect causes of the plurality of battery cells.

5. The battery management apparatus of claim 1, wherein the control unit is further configured to determine a required time from a maximum deviation occurrence time to a next maximum deviation occurrence time based on the voltage deviation cumulative data and the SOC deviation cumulative data and determine a deviation cause corresponding to the required time as the defect cause of the plurality of battery cells.

6. The battery management apparatus of claim 6, wherein the control unit is further configured to determine a maximum deviation occurrence speed based on the required time and determine a deviation cause corresponding to the maximum deviation occurrence speed as the defect cause of the plurality of battery cells.

7. The battery management apparatus of claim 1, wherein the control unit is further configured to reset the cumulative data based on that the voltage deviation cumulative data and the SOC deviation cumulative data falling within a normal range.

8. The battery management apparatus of claim 7, wherein the control unit is further configured to store a maximum deviation up to a reset time based on that the cumulative data is reset wherein a previously stored maximum deviation is compared with the maximum deviation up to the reset time and a greater value therebetween is stored.

9. A battery management method comprising:
measuring voltages and currents of a plurality of battery cells;
generating voltage deviation cumulative data obtained by accumulating a deviation between voltages of the plurality of battery cells;
determining states of charge (SOCs) of the plurality of battery cells based on the currents;
generating SOC deviation cumulative data obtained by accumulating a deviation between the SOCs of the plurality of battery cells; and
determining defect causes of the plurality of battery cells based on the voltage deviation cumulative data and the SOC deviation cumulative data.

10. The battery management method of claim 9, wherein the determining of the defect causes of the plurality of battery cells comprise determining increasing required times of a voltage deviation and a SOC deviation based on the voltage deviation cumulative data and the SOC deviation cumulative data, and determining deviation causes corresponding to the increasing required times as the defect causes of the plurality of battery cells.

11. The battery management method of claim 9, wherein the determining of the defect causes of the plurality of battery cells comprise determining deviation counts of a voltage deviation and a SOC deviation based on the voltage deviation cumulative data and the SOC deviation cumulative data, and determining deviation causes corresponding to the deviation counts as the defect causes of the plurality of battery cells.

12. The battery management method of claim 9, wherein the determining of the defect causes of the plurality of battery cells comprise determining maximum deviations of a voltage deviation and a SOC deviation based on the voltage deviation cumulative data and the SOC deviation cumulative data, and determining deviation causes corresponding to the maximum deviations as the defect causes of the plurality of battery cells.

13. The battery management method of claim 9, wherein the determining of the defect causes of the plurality of battery cells comprise determining a required time from a maximum deviation occurrence time to a next maximum deviation occurrence time based on the voltage deviation cumulative data and the SOC deviation cumulative data and determining a deviation cause corresponding to the required time as the defect cause of the plurality of battery cells.

14. The battery management method of claim 9, wherein the determining of the defect causes of the plurality of battery cells comprise determining a maximum deviation occurrence speed based on the required time and determining a deviation cause corresponding to the maximum deviation occurrence speed as the defect cause of the plurality of battery cells.

15. The battery management method of claim 9, further comprising resetting the cumulative data based on that the voltage deviation cumulative data and the SOC deviation cumulative data fall within a normal range.

16. The battery management method of claim 15, further comprising storing a maximum deviation up to a reset time based on that the cumulative data is reset wherein a previously stored maximum deviation is compared with the maximum deviation up to the reset time and a greater value therebetween is stored.
